# EUROPEAN PATENT APPLICATION

(11) **EP 1 826 260 A1**
(43) Date of publication of application: **29.08.2007**
(21) Application number: 06004014.4
(22) Date of filing: 28.02.2006
(51) Int. Cl.: C11D 7/26, H01L 21/306

(54) **Cleaning composition for removing impurities and method of removing impurities using the same**

(71) Applicant: Lee, Gi-Won, Gwonseon-gu Suwon-si, Gyeonggi-do (KR)
(72) Inventor: Lee, Ki Jeong, Ansan-si Gyeonggi-do (KR)
(74) Representative: Dr. Weitzel & Partner

(57) **Abstract**

In a cleaning composition for removing residual impurities from a substrate or an apparatus for forming an integrated circuit, and a method of removing the impurities using the cleaning composition, the cleaning composition includes about 4 to about 50 percent by weight of at least two compounds selected from the group consisting of citric acid, a citrate salt, a fluoride salt, hydrofluoric acid, hydrogen peroxide and ammonium persulfate, and a remainder of water. The cleaning composition may effectively remove residual impurities from the substrate or the apparatus, and may prevent the substrate or the apparatus from being recontaminated by the impurities.

## Description

### BACKGROUND OF THE INVENTION

### 1. Field of the Invention

Example embodiments of the present invention relate to a cleaning composition for removing impurities and a method of removing impurities using the cleaning composition. More particularly, example embodiments of the present invention relate to a cleaning composition for removing residual impurities from a substrate or an integrated circuit device, and a method of removing impurities using the cleaning composition.

### 2. Description of the Related Art

A wafer used in a process for manufacturing an integrated circuit is generally divided into a prime wafer and a test wafer (i.e., a dummy wafer). The prime wafer is used for manufacturing a semiconductor device such as an integrated circuit. The test wafer is used for checking each manufacturing process. The test wafer is processed in a manufacturing process of a semiconductor device with the prime wafer and serves as a buffer. The test wafer is also processed alone and temporarily used until the manufacturing process becomes settled.

After the manufacturing process, various impurities remain on a surface of the wafer. Kinds of the impurities are various according to a manufacturing process and generally number more than one. Examples of the impurities may include nonmetallic impurities such as SiNₓ, SiO₂, etc., metallic impurities such as Al, Ti, W, Cu, Ta, etc., a metal nitride, a metal silicide, and the like.

A recycling process is performed on the wafer including the impurities in order to remove the impurities from the wafer. The recycling process may include a chemical etching process, a grinding process, a polishing process, etc. Through the recycling process, a thickness of the wafer decreases by about 20µm to about 50µm in each recycling process. A decrease of the thickness has a negative influence on the number of recycling processes, by causing an increase in production costs. For example, when a standard thickness of an 8-inch wafer is 725 ± 25µm, a thickness of a recycled wafer is in a range of about 600µm to about 650µm. Accordingly, the number of times that the wafer can be recycled is restrictive. In addition, the wafer may not be uniformly etched according to a solution used in the recycling process, and stains may be generated on a surface of the wafer.

In a conventional chemical etching process of removing the impurities, an acid solution such as HCl, HF, HNO₃ or CH₃COOH is used to remove a metal layer including a metal such as Al, Fe or Zn. The acid solution is used alone or in a mixture thereof. A mixture of hydrochloric acid and hydrogen peroxide is often used. In addition, an acid solution such as HF, HNO₃, HCl, CH₃COOH or H₂SO₄ and an alkaline solution such as NaOH, KOH or NH₄OF are used to remove general impurities. The acid solution is incendiary under atmospheric pressure and very toxic.

An alkaline solution such as KOH, a mixture of NaOH and H₂O₂, a mixture of NH₄OH and H₂O₂ are used to remove impurities of a multilayered structure including a metal such as Ti, W, Cu, a metal nitride, a metal silicide or a mixture thereof.

The acid solution and the alkaline solution may be reacted with a metal, a metal nitride or a silicide thereof to generate a non-soluble reaction product. The reaction product may be re-absorbed on a substrate and cause contamination such as a stain. The substrate may be also etched by the reaction product. In addition, the acid solution and the alkaline solution including HF, HNO₃, HCl, NH₄OH, etc. are classified as toxic chemicals, so that use, application and discharge of the chemicals are strictly regulated. The acid and alkaline solutions are very toxic, and thus can deteriorate a processing environment. Direct skin contact or inhaling the vapor of the solutions can also be hazardous. Additionally, when a wafer having a large diameter is damaged by the solutions, a grinding process and a polishing process are additionally necessary for re-planarizing the wafer, thereby increasing processing costs.

Examples of an etching solution including the above-mentioned solutions are disclosed in Japanese Laid-Open Patent Publication No. 1999-302877. According to the above Japanese Laid-Open Patent Publication No. 1999-302877, in order to prepare an etching solution for removing a metal layer formed on a silicon substrate, about 5 to about 20 percent by weight of hydrogen fluoride (HF) and about 15 to about 30 percent by weight of nitric acid (HNO₃) are mixed. A mixture of hydrogen fluoride and nitric acid is made to have a concentration of about 20 to about 50 percent by weight. Acetic acid (CH₃COOH) is added to the mixture to form the etching solution. The etching solution is a mixed acid etchant (MAE) including hydrogen fluoride, nitric acid and acetic acid. In the etching solution, a range of each acid solution is simply adjusted so as to reduce a rapid etching rate. In addition, an additional etching process using an alkaline solution is required on the silicon substrate after being treated by the etching solution. Thus, the silicon substrate is unavoidably damaged.

Impurities are also attached and accumulated on an apparatus for forming an integrated circuit in a manufacturing process. The impurities include a material substantially the same or similar to the material deposited on a substrate in the manufacturing process. Accordingly, in order to reuse the apparatus, the impurities must be removed from the apparatus. A solution used for removing the impurities is different according to the apparatus and the impurities. An acid solution such as a hydrogen fluoride (HF) solution is conventionally used for removing a metal or a metal compound, and an alkaline solution such as NH₄OH is also used.

The apparatus for manufacturing a semiconductor device may include, for examples, ceramic (Al₂O₃), aluminum (Al), anodized aluminum, quartz (SiO₂) or an anticorrosive stainless metal. The apparatus includes a material that is not resistant to acid and alkali, so that a surface of the apparatus is unavoidably damaged in a removing process of the impurities. The apparatus has an irregular surface because of damage to the surface of the apparatus, and the irregular surface causes particles to be generated during the process. Hence, the quality of the object and the throughput of the recycling process of the object are deteriorated. Furthermore, the life of the apparatus becomes shortened.

### SUMMARY OF THE INVENTION

Example embodiments of the present invention provide a cleaning composition that may remove residual impurities from a substrate or an apparatus for forming an integrated circuit without damaging the substrate or the apparatus, and may reduce environmental contamination.

Example embodiments of the present invention also provide a method of removing residual impurities from a substrate or an apparatus using the cleaning composition.

According to one aspect of the present invention, a cleaning composition includes about 4 to about 50 percent by weight of at least two compounds selected from the group consisting of citric acid, a citrate salt, a fluoride salt, hydrofluoric acid, hydrogen peroxide and ammonium persulfate, and a remainder of water.

In an example embodiment of the present invention, the cleaning composition may include about 2 to about 25 percent by weight of the fluoride salt, about 2 to about 25 percent by weight of citric acid and a remainder of water.

In an example embodiment of the present invention, the cleaning composition may include about 2 to about 25 percent by weight of hydrofluoric acid, about 2 to about 25 percent by weight of citric acid, and a remainder of water.

In an example embodiment of the present invention, the cleaning composition may include about 2 to about 25 percent by weight of the citrate salt, about 2 to about 25 percent by weight of hydrogen peroxide, and a remainder of water.

In an example embodiment of the present invention, the cleaning composition may include about 2 to about 25 percent by weight of the fluoride salt, about 2 to about 25 percent by weight of ammonium persulfate, and a remainder of water.

According to another aspect of the present invention, there is provided a method of removing impurities. In the method, a cleaning composition including about 4 to about 50 percent by weight of at least two compounds selected from the group consisting of citric acid, a citrate salt, a fluoride salt, hydrofluoric acid, hydrogen peroxide and ammonium persulfate, and a remainder of water, is prepared. The cleaning composition is applied to a substrate or an apparatus for forming an integrated circuit to remove impurities from the substrate or the apparatus.

According to the present invention, the cleaning composition may effectively remove residual impurities from a substrate and may also prevent the substrate from being recontaminated by the impurities. In addition, the cleaning composition may have a high etching selectivity relative to the substrate, so that the cleaning composition may not damage the substrate and may not reduce a flatness of the substrate. A dummy wafer may be repeatedly cleaned using the cleaning composition without being damaged, so that the cleaning composition may greatly enhance the number of recycling times and may reduce recycling costs. Furthermore, the cleaning composition may effectively remove impurities that remain on an apparatus for forming an integrated circuit, without damage to the apparatus and generation of particles.

### BRIEF DESCRIPTION OF THE DRAWINGS

The above and other features and advantages of the present invention will become more apparent by describing in detailed example embodiments thereof with reference to the accompanying drawings, in which:
FIG. 1 is a picture showing a surface of a quartz focus ring before a cleaning process using an optical microscope;
FIG. 2 is a picture showing a surface of a quartz focus ring after a cleaning process of Example 3 using an optical microscope;
FIG. 3 is a picture showing a surface of a quartz focus ring after a cleaning process of the Comparative Example using an optical microscope;
FIG. 4 is a picture showing a surface of an N₂ shield before a cleaning process using an optical microscope;
FIG. 5 is a picture showing a surface of an N₂ shield after a cleaning process of Example 3 using an optical microscope;
FIG. 6 is a picture showing a surface of an N₂ shield after a cleaning process of Comparative Example using an optical microscope;
FIG. 7 is a picture showing a surface of a stainless metal substrate after a cleaning process of Example 3 using an optical microscope;
FIG. 8 is a picture showing a surface of a stainless metal substrate after a cleaning process of Comparative Example using an optical microscope;
FIG. 9 is a picture showing a surface of a ceramic focus ring before a cleaning process using an electron microscope;
FIG. 10 is a picture showing a surface of a ceramic focus ring after a cleaning process of Example 4 using an electron microscope;
FIG. 11 is a picture showing a surface of a ceramic focus ring after a cleaning process of Comparative Example using an electron microscope;
FIG. 12 is a picture showing a surface of a shower head before a cleaning process using an electron microscope;
FIG. 13 is a picture showing a surface of a shower head after a cleaning process of Example 4 using an electron microscope;
FIG. 14 is a graph illustrating a quantity of impurities that remain on a shower head before a cleaning process; and
FIG. 15 is a graph illustrating a quantity of impurities that remain on a shower head after a cleaning process of Example 4.

### DETAILED DESCRIPTION OF THE INVENTION

The present invention is described more fully hereinafter with reference to the accompanying drawings, in which example embodiments of the present invention are shown. The present invention may, however, be embodied in many different forms and should not be construed as limited to the example embodiments set forth herein. Rather, these embodiments are provided so that this disclosure will be thorough and complete, and will fully convey the scope of the present invention to those skilled in the art.

The terminology used herein is for the purpose of describing particular embodiments only and is not intended to be limiting of the present invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

### Cleaning Composition for Removing Impurities

A cleaning composition of the present invention may be applied to a cleaning process for removing residual impurities from a substrate for forming an integrated circuit or an apparatus used for forming the integrated circuit on the substrate. The cleaning composition includes about 4 to about 50 percent by weight of at least two compounds selected from the group consisting of citric acid, a citrate salt, a fluoride salt, hydrofluoric acid, hydrogen peroxide and ammonium persulfate, and a remainder of water. The cleaning composition may effectively remove impurities that remain on the substrate or the apparatus for forming an integrated circuit device without damaging the substrate or the apparatus, and may reduce environmental contamination.

Particularly, the cleaning composition may effectively remove residual impurities from a substrate or an apparatus and may also prevent the substrate or the apparatus from being recontaminated by the impurities.

In addition, the cleaning composition may have a high etching selectivity relative to a substrate, so that the cleaning composition may not damage the substrate and may not deteriorate a flatness of the substrate.

A substrate or an apparatus may be repeatedly cleaned using the cleaning composition without being damaged, so that the cleaning composition may greatly enhance the number of recycling times and may reduce recycling costs. Furthermore, the cleaning composition may effectively remove impurities that remain on the apparatus used for forming an integrated circuit, without damage to the apparatus and generation of particles.

Examples of the impurities that remain on a substrate or an apparatus for forming an integrated circuit, may include aluminum (AI), titanium (Ti), tungsten (W), copper (Cu), aluminum nitride (AINₓ), titanium nitride (TiNₓ), tungsten nitride (WNₓ), copper nitride (CuNₓ), aluminum silicide (AISiₓ), titanium silicide (TiSiₓ), tungsten silicide (WSiₓ), silicon oxide (SiO₂), silicon nitride (SiNₓ) or indium tin oxide (ITO). These may remain on the substrate or the part alone or in a mixture thereof.

A substrate used for forming in an integrated circuit may include a silicon wafer. After removing the impurities using the cleaning composition, the substrate may be cleaned using an SC-1 solution including ammonium hydroxide (NH₄OH), hydrogen peroxide (H₂O₂) and water, or an SC-2 solution including hydrochloric acid (HCI), hydrogen peroxide (H₂O₂) and water. An apparatus used for forming an integrated circuit may include a material such as a ceramic, aluminum, quartz, a stainless metal, etc.

In one example embodiment of the present invention, the cleaning composition may include about 2 to about 25 percent by weight of a fluoride salt, about 2 to about 25 percent by weight of citric acid, and a remainder of water.

An example of the fluoride salt that may be used in the cleaning composition may include ammonium hydrogen difluoride (NH₄HF₂). Ammonium hydrogen difluoride is ionized into M^{I} [HF₂]⁻ (M^{I} = NH₄⁺) in aqueous solution, and is reacted with the impurities such as SiO₂, WSi₂, Si₃N₄, Al, Ti or Fe as shown in the following reaction formulae 1, respectively. The impurities may be combined with NH₄⁺ ion in aqueous solution to form a water-soluble complex.

M^{I} [HF₂]⁻ + SiO₂ → M₂^{I} [SiF₆];

M^{I} [HF₂]⁻ + WSi₂ → M₂^{I} [WO₂F₄], M₂^{I} [SiF₆];

M^{I} [HF₂]⁻ + SbN₄ → M₂^{I} [SiF₆];

M^{I} [HF₂]⁻ + Al → M₂^{I} [AlF₆];

M^{I} [HF₂]⁻ + Ti → M₂^{I} [TiF₆]; or

M^{I} [HF₂]⁻ + Fe → M₂^{I} [FeF₅(OH)₂] ...... (1)

In addition, the cleaning composition may include hydrofluoric acid (HF) instead of the fluoride salt. The cleaning composition may include about 2 to about 25 percent by weight of hydrofluoric acid, about 2 to about 25 percent by weight of citric acid, and a remainder of water. Hydrofluoric acid is ionized into H⁺ and F⁻ in aqueous solution. F⁻ ion may be reacted with all kinds of a metal to generate water-soluble or water-insoluble compounds such as TiF₃, TiF₄, WF₄, WF₆, AlF₃, CuF₂, SbF₃, etc. When hydrofluoric acid alone is used in a cleaning process, the water-soluble or water-insoluble compounds may be reacted with a silicon wafer and may be absorbed onto the silicon wafer by an electrical characteristic to generate stain-type contamination.

Citric acid (C₆H₈O₇) included in the cleaning composition is ionized into 3H⁺ and [C₆H₅O₇]³⁻. Citric acid may be reacted with a metallic ion such as zinc ion, chromium ion, copper (II) ion, aluminum ion, iron (III) ion and the like to generate a colorless water-soluble complex. Examples of the complex may include AlC₆H₅O₇, FeC₆H₅O₇, [Fe₃(OH)₂(OH)₂(C₆H₅O₇)₂](CeH₅O₇), H₆[Fe₂(C₆H₅O₇)_{3]}, Ca₃(C₆H₅O₇)₂, Zn₃(C₆H₅O₇)₂, Ni₃(C₆H₅O₇)₂, MgHC₆H₅O₇, etc.

As a result, ammonium hydrogen difluoride or hydrofluoric acid included in the cleaning composition may be reacted with the impurities that remain on the substrate or the apparatus to remove the impurities from the substrate or the apparatus and to generate a reaction product such as an ammonium salt or a metal salt. Simultaneously, citric acid may be reacted with the reaction product to generate a water-soluble complex, so that citric acid may prevent the reaction product from being re-absorbed onto the substrate or the apparatus. Furthermore, the cleaning composition including ammonium hydrogen difluoride, citric acid and water may have a high etching selectivity relative to a silicon wafer. Thus, the cleaning composition may not etch or damage the silicon wafer in a cleaning process.

In another example embodiment of the present invention, a cleaning composition may include hydrogen peroxide, a citrate salt and water. Preferably, the cleaning composition may include about 2 to about 25 percent by weight of hydrogen peroxide, about 2 to about 25 percent by weight of the citrate salt, and a remainder of water.

Hydrogen peroxide included in the cleaning composition may be dissolved in aqueous solution to oxidize a metal of the impurities. Examples of the citrate salt that may be used in the cleaning composition may include an anhydrous citrate salt, a hydrated citrate salt, etc. The citrate salt in the cleaning composition may be reacted with a metal oxide formed by a reaction between hydrogen peroxide and the metal of the impurities, to generate a water-soluble complex. For example, hydrogen peroxide is decomposed to generate oxygen, and oxygen is reacted with the metal of the impurities to form a metal oxide as shown in the following reaction formulae 2.

H₂O₂ → O₂ + 2H⁺ +2e⁻

Ti + O₂ → TiO₂, TiO₃

W + O₂ → WO₃, W₂O₅, W₂O₃ ...... (2)

The metal oxide may be reacted with sodium citrate 9Na₃C₆H₅O₇) to form a water-soluble complex as shown in the following reaction formulae 3.

Na₃C₆H₅O₇ + WOₓ → W[C₆H₅O₇]

Na₃C₆H₅O₇ + TiOₓ → Ti[C₆H₅O₇] ...... (3)

Hydrogen peroxide included in the cleaning composition may generate oxygen and may be reacted with the impurities that remain on the substrate or the apparatus to oxidize the impurities. That is, hydrogen peroxide may be reacted with a metal to form a metal oxide. Simultaneously, the citrate salt may be reacted with the metal oxide that is a reaction product of hydrogen peroxide with the impurities to generate a water-soluble complex, so that citrate salt may prevent the reaction product from being re-absorbed onto the substrate or the apparatus. Furthermore, the cleaning composition including hydrogen peroxide, the citrate salt and water may have a high etching selectivity relative to a silicon wafer. Thus, the cleaning composition may not etch or damage the silicon wafer in a cleaning process.

The cleaning composition in accordance with an example embodiment of the present invention may be used to remove impurities that remain on an apparatus for forming an integrated circuit. The cleaning composition may effectively remove the impurities that remain on the apparatus without damaging the apparatus. In addition, the cleaning composition may prevent generation of particles by removing the impurities and may remarkably extend a life of the apparatus. Furthermore, the cleaning solution may not include an incendiary or toxic material and may not cause an environmental contamination.

Examples of the impurities that remain on an apparatus used for forming an integrated circuit may include a metal such as aluminum (Al), titanium (Ti), tungsten (W), copper (Cu), etc., a metal nitride such as aluminum nitride (AINₓ), titanium nitride (TiNₓ), tungsten nitride (WNₓ), copper nitride (CuNₓ), etc., a silicide such as aluminum silicide (AlSiₓ), titanium silicide (TiSiₓ), tungsten silicide (WSiₓ), etc., silicon oxide (SiO₂), silicon nitride (SiNₓ) or indium tin oxide (ITO). The impurities that remain on the apparatus used for forming an integrated circuit may be roughly deposited, differently from a substrate. In addition, gas used for forming an integrated circuit may be diverse according to a purpose of process, so that the impurities may include various and complex components.

Examples of gas used for forming the integrated circuit may include an inorganic gas including O₂, N₂, Ar₂, He₂, H₂S, NH₃, N₂O, a hydrogen compound gas including SH₄, Si₂H₆, PH₃, AsH₃, SbH₃, SeH₂, H₂Te, GeH₄, B₂H₆, a halogen compound gas including BCl₃, BF₃, Cl₂, HCl, CCl₄, CFH₃, C₃F₈, PF₃, PF₅, POCl₃, SiH₂Cl, SiCl₄, PCl₃, AsCl₃ or an organic metal compound gas including (CH₃)₂Zn, (C₂H₃)₂Zn, (CH₃)₂Cd, (C₂H₃)₂Cd, etc.

Ammonium hydrogen difluoride (NH₄HF₂) included in the cleaning composition may be reacted with all kinds of a metal and impurities that remain on the substrate or the apparatus in a manufacturing process. Thus, ammonium hydrogen difluoride may generate a complex including hydrofluoric acid (HF) by a reaction with the metals and the impurities as shown in the above reaction formulae 1.

Ammonium persulfate ((NH₄)₂S₂O₈) included in the cleaning composition may be dissolved into ammonium sulfate (NH₄HSO₄) and hydrogen peroxide (H₂O₂) in aqueous solution as shown in the following reaction formulae 4. Thus, ammonium persulfate may oxidize the impurities that remain on the substrate or the apparatus. Hydrogen peroxide may prevent a reaction product of ammonium hydrogen difluoride and the impurities from being re-absorbed onto the substrate or the apparatus.

(NH₄)₂S₂O₈ + 2H₂O → 2NH₄HSO₄ + H₂O₂

2H₂O₂ → 2H₂O + O₂ ...... (4)

The cleaning composition may effectively remove the impurities that remain on an apparatus including ceramic, aluminum (Al₂O₃), quartz (SiO₂), a stainless metal, etc. The cleaning solution may be hardly reacted with ceramic and may be very weakly reacted with quartz and the stainless metal. Thus, the cleaning composition may be actively reacted with the impurities without changing a shape or a dimension of the apparatus, so that the cleaning composition may finely etch the impurities of the apparatus.

### Method of Removing Impurities

A method of removing impurities of the present invention may be performed for removing residual impurities from a substrate for forming an integrated circuit or an apparatus used for forming the integrated circuit without damaging the substrate or the apparatus, and may prevent environmental contamination.

In the method of removing impurities, a cleaning composition is prepared. The cleaning composition includes about 4 to about 50 percent by weight of at least two compounds selected from the group consisting of citric acid, a citrate salt, a fluoride salt, hydrofluoric acid, hydrogen peroxide and ammonium persulfate, and a remainder of water. The cleaning composition may be substantially the same as a cleaning composition that is described above.

The impurities are removed from the substrate or the apparatus using the cleaning composition. In one example embodiment of the present invention, the substrate or the apparatus including the impurities may be immersed in a cleaning bath including the cleaning composition. In another example embodiment of the present invention, an ultrasonic cleaning process may be further carried out for the substrate or the apparatus.

The substrate may include a silicon wafer, a test wafer (a dummy wafer), etc. The apparatus may include an equipment, an apparatus or a part thereof that may be used to a manufacturing process such as an etching process, a deposition process, etc. The apparatus may include, for example, aluminum, a stainless metal, quartz or ceramic, etc. Examples of the impurities that remain on the substrate or the apparatus, may include aluminum (Al), titanium (Ti), tungsten (W), copper (Cu), aluminum nitride (AlNₓ), titanium nitride (TiNₓ), tungsten nitride (WNₓ), copper nitride (CuNₓ), aluminum silicide (AlSiₓ), titanium silicide (TiSiₓ), tungsten silicide (WSiₓ), silicon oxide (SiO₂), silicon nitride (SiNₓ) or indium tin oxide (ITO). The impurities may remain alone or in a mixture thereof.

After removing the impurities using the cleaning composition, an additional cleaning process may be further performed for the substrate or the apparatus using an SC-1 solution or an SC-2 solution. The additional cleaning process using the SC-1 solution or the SC-2 solution may substantially entirely remove metal ions that remain on the substrate or the apparatus to a level below a permissible range.

In the method of removing impurities according to the present invention, the cleaning composition may not be reacted with ceramic, quartz and a stainless metal. Thus, when impurities that remain on a substrate or an apparatus including ceramic, quartz and the stainless metal are removed, the impurities may be effectively removed without damaging the substrate or the apparatus.

### Example 1

A first cleaning composition was prepared. The first cleaning composition included about 12 percent by weight of ammonium hydrogen difluoride (NH₄HF₂), about 12 percent by weight of Citric acid (C₆H₈O₇) and about 76 percent by weight of water.

8-inch silicon wafers including impurities of different kinds were immersed into a cleaning bath including the first cleaning solution by ten sheets, respectively. Then, the silicon wafers were cleaned by spraying deionized water, and treated in deionized water with ultrasonic waves of about 40kHz for about 120 seconds. A spin-drying process was performed for the silicon wafer. Kinds, components and thicknesses of the impurities included in the silicon wafer, and immersing temperatures and times of the cleaning solution are shown in the following Table 1.

**Table 1**

| Kinds of Impurities | Components of Impurities | Thickness of Impurities (nm) | Immersing Temperature (°C) | Immersing Time (seconds) |
|---|---|---|---|---|
| AP TEOS | SiO₂ | 600 | 25 | 60 |
| LP TEOS | SiO₂ | 650 | 25 | 10 |
| HDP USG | SiO₂ | 1600 | 25 | 90 |
| AP-CVD BPSG | SiO₂ | 350 | 25 | 10 |
| Plasma TEOS | SiO₂ | 50 | 25 | 10 |
| HTO | SiN | 700 | 25 | 60 |
| LP SiN | SiN | 210 | 60 | 660 |
| Plasma SiN | SiN | 750 | 25 | 90 |
| P, SiN | P, SiN | 330 | 60 | 90 |
| P, SiN | P, SiN | 330 | 25 | 900 |
| Plasma SiON | SiON | 30 | 25 | 10 |
| Al, SiO₂ | Al, SiO₂ | 200/500 | 25 | 120 |
| TiN, SiO₂ | TiN, SiO₂ | 100/300 | 25 | 120 |
| Ti, SiO₂ | Ti, SiO₂ | 130/50 | 25 | 20 |
| P-TEOS, W | P, SiO₂, W | 220 | 25 | 80 |
| Al, Ti, W, WSi | Al, Ti, W, WSi | - | 60 | 600 |
| ITO | In₂O₃, SiO₂ | 700 | 25 | 60 |

As a result, the first cleaning composition removed various impurities having conditions illustrated in Table 1. In addition, the impurities that remain on the silicon wafers were substantially completely removed without damaging the silicon wafers.

### Evaluation I of Contamination of Metal Ions

In order to evaluate a contamination for silicon wafers after a cleaning process according to Example 1, a total reflection X-ray fluorescene (TXRF) method was performed for the silicon wafers after a cleaning process according to Example 1. The TXRF method is a method commonly used for measuring a metal contamination level. The silicon wafers of 170 sheets were divided into 5 groups, so the metal contamination level of the silicon wafers was measured by 34 sheets. Measurement results are shown in the following Table 2.

**Table 2**

| | Ti | Cr | Mn | Fe | Ni | Cu | Ca | Zn |
|---|---|---|---|---|---|---|---|---|
| Group 1 | 1.1 | ND | ND | 2.3 | ND | 24.2 | 64.1 | ND |
| Group 2 | 3.4 | 2.7 | ND | 2.5 | ND | 32.2 | 52.1 | ND |
| Group 3 | 2.2 | 4.2 | ND | ND | ND | 12.9 | 48.0 | ND |
| Group 4 | 2.9 | ND | ND | 3.3 | 1.3 | 21.2 | 30.4 | ND |
| Group 5 | 3.9 | 7.0 | ND | 1.2 | 1.4 | 12.9 | 33.2 | ND |

| | | | | | | | | |
|---|---|---|---|---|---|---|---|---|
| (unit: *10¹⁰ atom/cm², ND: not detected) | | | | | | | | |

In a manufacturing process of a semiconductor device, a permissible contamination level may be generally below about 5.0*10¹⁰atom/cm². In a first evaluation, Mn and Zn were not totally detected in the silicon wafers. Ti, Cr, Fe and Ni were detected in a permissible range. However, Cu and Ca were at a contamination level beyond the permissible range.

### Evaluation II of Contamination of Metal Ions

After a cleaning process of Example 1, an additional cleaning process was performed for silicon wafers using an SC-1 solution or an SC-2 solution for about 300 seconds. After the additional cleaning process, the silicon wafers were cleaned by spraying deionized water. Then, a spin-drying process was performed for the silicon wafers. A metal contamination level of the silicon wafers was measured by a TXRF method. Then, the silicon wafers of 170 sheets were divided into 5 groups, so the silicon wafers were measured by 34 sheets. The measurement results are shown in the following Table 3.

**Table 3**

| | Ti | Cr | Mn | Fe | Ni | Cu | Ca | Zn |
|---|---|---|---|---|---|---|---|---|
| Group 1 | ND | ND | ND | ND | ND | ND | ND | ND |
| Group 2 | 1.7 | ND | ND | ND | ND | ND | ND | ND |
| Group 3 | ND | 1.2 | ND | ND | ND | ND | ND | ND |
| Group 4 | ND | ND | ND | 0.8 | 1.3 | 0.6 | ND | ND |
| Group 5 | 1.1 | ND | ND | ND | 1.4 | ND | ND | ND |

| | | | | | | | | |
|---|---|---|---|---|---|---|---|---|
| (unit: *10¹⁰ atom/cm², ND: not detected) | | | | | | | | |

As shown in Table 3, Ti, Cr, Fe, Ni and Cu ions were detected below a permissible range or totally not detected by performing the additional cleaning process. That is, impurities are removed using a cleaning composition of the present invention, residual metal ions of a small quantity are removed by the additional cleaning process using the SC-1 solution or the SC-2 solution.

### Example 2

A second cleaning composition was prepared. The second cleaning composition included about 12 percent by weight of hydrogen peroxide (H₂O₂), about 12 percent by weight of sodium citrate (Na₃C₆H₅O₇) and about 76 percent by weight of water.

8-inch silicon wafers that a silicon oxide layer and a tungsten layer are successively formed thereon were prepared. The silicon wafers of ten sheets were immersed into the second cleaning solution to remove the tungsten layer from the silicon wafers. Then, the silicon oxide layer of the silicon wafers was successively removed from the silicon wafers using the second cleaning solution. After the silicon wafers were cleaned by spraying deionized water, and treated in deionized water with ultrasonic waves of about 40kHz for about 120seconds. Then, a spin-drying process was performed for the silicon wafers. Kinds, components and thicknesses of the impurities included in the silicon wafer, and immersing temperatures and times of the cleaning solution are shown in the following Table 4.

**Table 4**

| Kinds of Impurities | Components of Impurities | Thickness (nm) | Temperature (°C) | Time (seconds) |
|---|---|---|---|---|
| W, SiO₂ | W, SiO₂ | 60 | 80 | 120 |
| SiO₂ | SiO₂ | 200 | 25 | 160 |

As a result, the second cleaning composition removed impurities having conditions illustrated in Table 4.

### Evaluation III of Contamination of Metal Ions

After a cleaning process of Example 2, an additional cleaning process was performed for silicon wafers using an SC-1 solution or an SC-2 solution for about 300 seconds. After the additional cleaning process, the silicon wafers were cleaned by spraying deionized water. Then, a spin-drying process was performed for the silicon wafers. Then, the silicon wafers of 170 sheets were divided into 5 groups, a metal contamination level of the silicon wafers of Group I was measured by a TXRF method. The measurement results are shown in the following Table 5.

**Table 5**

| | Ti | Cr | Mn | Fe | Ni | Cu | Ca | Zn |
|---|---|---|---|---|---|---|---|---|
| Group 1 | 2.4 | ND | ND | ND | 0.8 | ND | ND | ND |

| | | | | | | | | |
|---|---|---|---|---|---|---|---|---|
| (unit: *10¹⁰ atom/cm², ND: not detected) | | | | | | | | |

As shown in Table 5, the metal contamination level of the silicon wafers that were performed by a cleaning process using a second cleaning composition, and the SC-1 solution or the SC-2 solution was in permissible range.

### Example 3

A third cleaning composition was prepared. The third cleaning composition included about 12 percent by weight of ammonium persulfate ((NH₄)₂S₂O₈), about 12 percent by weight of ammonium hydrogen difluoride (NH₄HF₂) and about 76 percent by weight of water. A quartz focus ring including quartz (SiO₂), an N₂ shield including a stainless metal and a substrate including a stainless metal were immersed into a bath including the third cleaning composition at a temperature of about 25°C for about 30 minutes, cleaned using ultrasonic waves and dryed, respectively.

The quartz focus ring used in a dry etching process included quartz. Impurities including Si, C and F remained on the quartz focus ring.

The N₂ shield used in a manufacturing process of a semiconductor device included SUS-316L that is a stainless metal. Impurities including an oxide of Fe, Ni, Cr, and Si02 remained on the N₂ shield.

The substrate included SUS-304 that is a stainless metal. Impurities including an oxide of Fe, Ni, Cr remained on the substrate.

### Example 4

A fourth cleaning composition was prepared. The fourth cleaning composition included about 12 percent by weight of hydrogen peroxide (H₂O₂), about 12 percent by weight of sodium citrate (Na₃C₆H₅O₇) and about 76 percent by weight of water. A ceramic focus ring and a shower head were immersed into a bath including the fourth cleaning composition at a temperature of about 80°C for about 30 minutes, cleaned using ultrasonic waves and dryed, respectively.

The ceramic focus ring used in a dry etching process included ceramic (Al₂SiO₂). Impurities including Si, C and F remained on the ceramic focus ring.

The shower head is used in a chemical mechanical deposition process. Impurities including C and F remained on the shower head.

### Comparative Example

A comparative cleaning composition including about 20 percent by weight of hydrofluoric acid having a concentration of about 50 percent and about 80 percent by weight of water was prepared. A quartz focus ring including quartz, an N₂ shield including a stainless metal, a substrate including a stainless metal and a ceramic focus ring including ceramic were immersed into a bath including the comparative cleaning composition at a temperature of about 25°C for about 30 minutes, cleaned using ultrasonic waves and dryed, respectively.

### Evaluation of Cleaning Compositions of Examples 3 and 4, and Comparative Example

A surface roughness of an apparatus was measured before and after cleaning the apparatus using a third cleaning composition of Examples 3, a fourth cleaning composition of Examples 3 and a comparative cleaning composition of Comparative Example, respectively. The surface of the apparatus was observed with an optical microscope or an electron microscope. The results are shown in the following Table 6.

**Table 6**

| | Surface Roughness (Ra, µm) | Surface Roughness (Rt, µm) | Change in a Surface |
|---|---|---|---|
| A quartz focus ring before a cleaning process | 0.01 | 0.13 | FIG. 1 |
| A quartz focus ring after a cleaning process of Example 3 | 0.03 | 0.30 | Slight change (FIG. 2) |
| A quartz focus ring after a cleaning process of Comparative Example | 0.61 | 5.06 | Remarkable change (FIG. 3) |
| An N₂ shield before a cleaning process | 0.01 | 0.12 | FIG. 4 |
| An N₂ shield after a cleaning process of Example 3 | 0.07 | 0.57 | Slight change (FIG. 5) |
| An N₂ shield after a cleaning process of Comparative Example | 0.23 | 2.43 | Remarkable change (FIG. 6) |
| A substrate after a cleaning process of Example 3 | - | - | Slight change (FIG. 7) |
| A substrate after a cleaning process of Comparative Example | - | - | Remarkable change (FIG. 8) |
| A ceramic focus ring before a cleaning process | - | - | FIG. 9 |
| A ceramic focus ring after a cleaning process of Example 4 | - | - | No residue (FIG. 10) |
| A ceramic focus ring after a cleaning process of Comparative Example | - | - | Minute piece remaining (FIG. 11) |
| A shower head before a cleaning process | - | - | Residue (FIG. 12) F and C remaining (FIG. 14) |
| A shower head after a cleaning process of Example 4 | - | - | No residue (FIG. 13) No F and C (FIG. 15) |

Ra represents an arithmetical mean roughness and Rt represents a max height roughness.

### Evaluation of Cleaning Composition for a Quartz Focus Ring

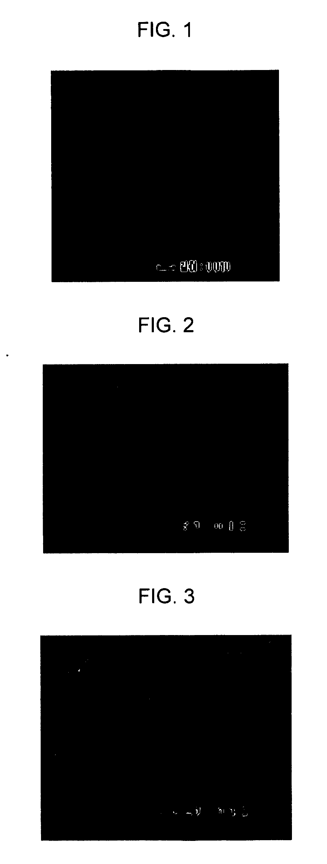

FIG. 1 is a picture showing a surface of a quartz focus ring before a cleaning process using an optical microscope. FIG. 2 is a picture showing a surface of a quartz focus ring after a cleaning process of Example 3 using an optical microscope. FIG. 3 is a picture showing a surface of a quartz focus ring after a cleaning process of Comparative Example using an optical microscope.

Referring to Table 6 and FIGS. 1 to 3, a surface roughness of a quartz focus ring after a cleaning process of Comparative Example was remarkably changed in comparison with the quartz focus ring after a cleaning process of Example 3. In addition, referring to FIG. 3, the structure of the quartz focus ring after the cleaning process of the Comparative Example was seriously eroded away. A surface change due to erosion may generate particles in a manufacturing process of a semiconductor device.

### Evaluation of Cleaning Composition for an N₂ shield

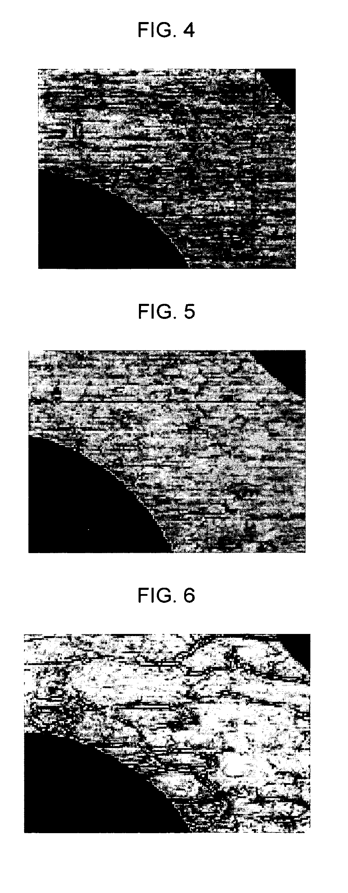

FIG. 4 is a picture showing a surface of an N₂ shield before a cleaning process using an optical microscope. FIG. 5 is a picture showing a surface of an N₂ shield after a cleaning process of Example 3 using an optical microscope. FIG. 6 is a picture showing a surface of an N₂ shield after a cleaning process of the Comparative Example using an optical microscope.

Referring to Table 6 and FIGS. 4 to 6, a surface roughness of an N₂ shield after a cleaning process of the Comparative Example was remarkably changed in comparison with the N₂ shield after a cleaning process of Example 3. In addition, referring to FIG. 6, a construction of the N₂ shield after a cleaning process of the Comparative Example was seriously eroded away. A surface change due to erosion may generate particles in a manufacturing process of a semiconductor device.

### Evaluation of Cleaning Composition for a Substrate

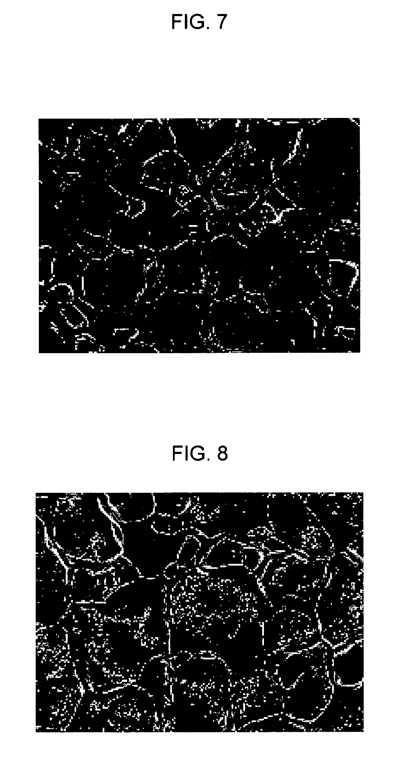

FIG. 7 is a picture showing a surface of a stainless metal substrate after a cleaning process of Example 3 using an optical microscope. FIG. 8 is a picture showing a surface of a stainless metal substrate after a cleaning process of the Comparative Example using an optical microscope.

Referring to FIG. 8, a construction of a stainless metal substrate after a cleaning process of the Comparative Example was seriously eroded away according to grain boundaries of the stainless metal substrate. However, referring to FIG. 7, a construction of a stainless metal substrate after a cleaning process of Example 3 was hardly eroded away according to grain boundaries of the stainless metal substrate.

### Evaluation of Cleaning Composition for a Ceramic Focus Ring

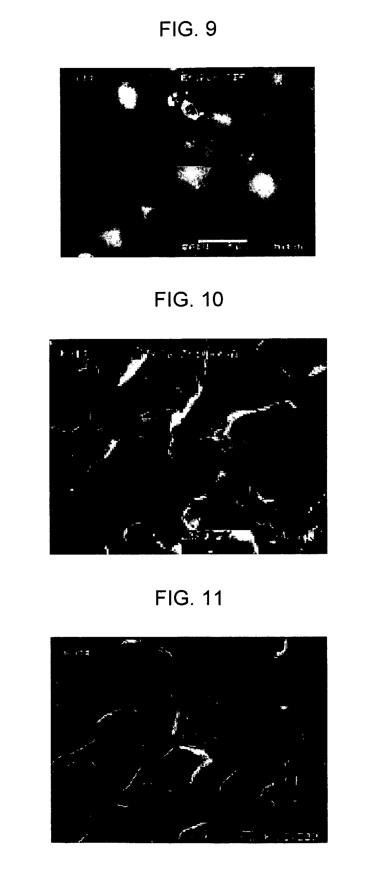

FIG. 9 is a picture showing a surface of a ceramic focus ring before a cleaning process using an electron microscope. FIG. 10 is a picture showing a surface of a ceramic focus ring after a cleaning process of Example 4 using an electron microscope. FIG. 11 is a picture showing a surface of a ceramic focus ring after a cleaning process of the Comparative Example using an electron microscope.

Referring to FIG. 11, particles having dimensions of about 0.1 µm to about 1.0µm remained in various spots on a surface of a ceramic focus ring after a cleaning process of the Comparative Example. However, referring to FIG. 10, particles did not remain on a ceramic focus ring after a cleaning process of Example 4.

### Evaluation of Cleaning Composition for a Shower Head

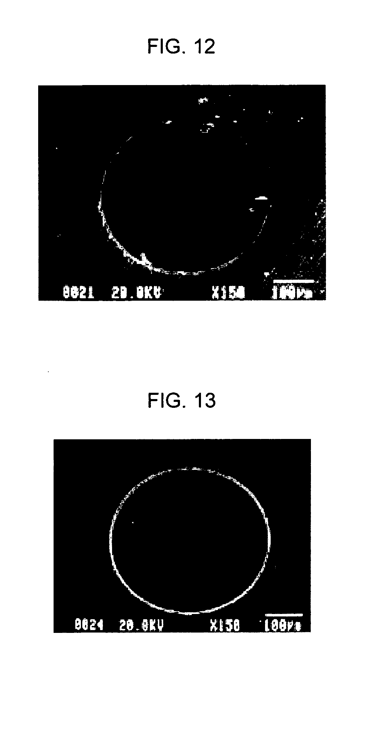

FIG. 12 is a picture showing a surface of a shower head before a cleaning process using an electron microscope. FIG. 13 is a picture showing a surface of a shower head after a cleaning process of Example 4 using an electron microscope.

Referring to FIG. 12, impurities such as particles remained on a surface of a shower head before a cleaning process. However, referring to FIG. 13, the impurities were totally removed on a shower head after a cleaning process of Example 4.

### Evaluation of Impurities that Remains on a Shower Head

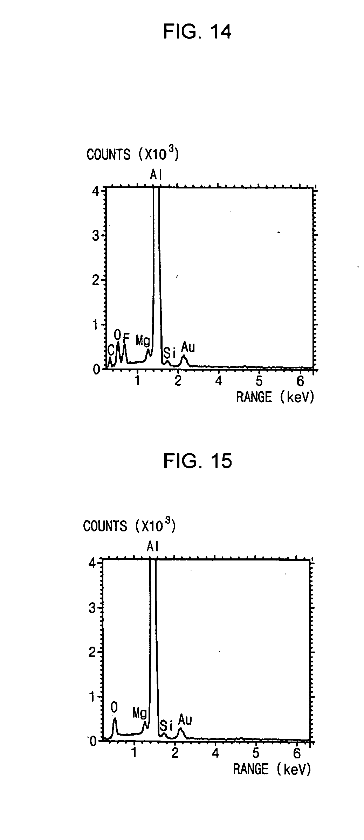

FIG. 14 is a graph illustrating a quantity of impurities that remain on a shower head before a cleaning process. FIG. 15 is a graph illustrating a quantity of impurities that remain on a shower head after a cleaning process of Example 4. A quantity of impurities on a shower head was measured using an electron probe micro-analysis (EPMA).

Referring to FIG. 14, a carbon (C) ion and a fluoride (F) ion were detected on a shower head before a cleaning process. However, referring to FIG. 15, a carbon (C) ion and a fluoride (F) ion were not detected on a shower head after a cleaning process of Example 4.

As described above, when impurities that remain on a substrate or an apparatus are removed using a cleaning composition of the present invention, the impurities may be substantially completely removed without damaging to a surface of the substrate or the apparatus.

A cleaning composition according to the present invention may effectively remove residual impurities from a substrate for forming an integrated circuit and may also prevent the substrate from being recontaminated by the impurities. In addition, the cleaning composition may have a high etching selectivity relative to the substrate, so that the cleaning composition may not damage the substrate and may not deteriorate flatness of the substrate. The cleaning composition may not erode the substrate, so that the cleaning composition may greatly enhance the number of recycling times and may reduce recycling costs. In addition, the cleaning composition may effectively remove impurities that remain on an apparatus used for forming an integrated circuit without damage to the apparatus and without generation of particles.

The foregoing is illustrative of the present invention and is not to be construed as limiting thereof. Although a few example embodiments of the present invention have been described, those skilled in the art will readily appreciate that many modifications are possible in the example embodiments without materially departing from the novel teachings and advantages of the present invention. Accordingly, all such modifications are intended to be included within the scope of the present invention as defined in the claims. In the claims, means-plus-function clauses are intended to cover the structures described herein as performing the recited function and not only structural equivalents but also equivalent structures. Therefore, it is to be understood that the foregoing is illustrative of the present invention and is not to be construed as limited to the specific embodiments disclosed, and that modifications to the disclosed embodiments, as well as other embodiments, are intended to be included within the scope of the appended claims. The present invention is defined by the following claims, with equivalents of the claims to be included therein.

## Claims

1. A cleaning composition for removing impurities comprising:
about 4 to about 50 percent by weight of at least two compounds selected from the group consisting of citric acid, a citrate salt, a fluoride salt, hydrofluoric acid, hydrogen peroxide and ammonium persulfate; and
a remainder of water.

2. The cleaning composition of claim 1, wherein the compounds comprise the fluoride salt and citric acid.

3. The cleaning composition of claim 2, wherein the cleaning composition comprises:
about 2 to about 25 percent by weight of the fluoride salt;
about 2 to about 25 percent by weight of citric acid; and
a remainder of water.

4. The cleaning composition of claim 1, wherein the compounds comprise hydrofluoric acid and citric acid.

5. The cleaning composition of claim 4, wherein the cleaning composition comprises:
about 2 to about 25 percent by weight of hydrofluoric acid;
about 2 to about 25 percent by weight of citric acid; and
a remainder of water.

6. The cleaning composition of claim 1, wherein the compounds comprise the citrate salt and hydrogen peroxide.

7. The cleaning composition of claim 6, wherein the cleaning composition comprises:
about 2 to about 25 percent by weight of the citrate salt;
about 2 to about 25 percent by weight of hydrogen peroxide; and
a remainder of water.

8. A method of removing impurities comprising:
preparing a cleaning composition including about 4 to about 50 percent by weight of at least two compounds selected from the group consisting of citric acid, a citrate salt, a fluoride salt, hydrofluoric acid, hydrogen peroxide and ammonium persulfate, and a remainder of water; and
removing the impurities from a substrate or an apparatus for forming an integrated circuit using the cleaning composition.

9. The method of claim 8, wherein the cleaning composition comprises:
about 2 to about 25 percent by weight of the fluoride salt;
about 2 to about 25 percent by weight of citric acid; and
a remainder of water.

10. The method of claim 8, wherein the cleaning composition comprises:
about 2 to about 25 percent by weight of hydrofluoric acid;
about 2 to about 25 percent by weight of citric acid; and
a remainder of water.

11. The method of claim 8, wherein the cleaning composition comprises:
about 2 to about 25 percent by weight of the citrate salt;
about 2 to about 25 percent by weight of hydrogen peroxide; and
a remainder of water.

12. The method of claim 8, wherein the impurities comprises at least one selected from the group consisting of aluminum, titanium, tungsten, copper, aluminum nitride, titanium nitride, tungsten nitride, copper nitride, aluminum silicide, titanium silicide, tungsten silicide, silicon oxide, silicon nitride and indium tin oxide (ITO).

13. The method of claim 8, wherein the substrate comprises a silicon wafer or a dummy wafer.

14. The method of claim 8, wherein the apparatus comprises at least one material selected from the group consisting of ceramic, aluminum, quartz and a stainless metal.

15. The method of claim 8, after removing the impurities using the cleaning composition, further comprising cleaning the substrate or the apparatus using an SC-1 solution including ammonium hydroxide, hydrogen peroxide and water, or an SC-2 solution including hydrochloric acid, hydrogen peroxide and water.

## Amended claims

### Amended claims in accordance with Rule 86(2) EPC.

**1.** A cleaning composition for removing impurities comprising:
about 4 to about 50 percent by weight of citrate salt and hydrogen peroxide; and
a remainder of water.

**2.** The cleaning composition of claim 1, wherein the cleaning composition comprises:
about 2 to about 25 percent by weight of the citrate salt;
about 2 to about 25 percent by weight of hydrogen peroxide; and
a remainder of water.

**3.** A method of removing impurities comprising:
preparing a cleaning composition including about 4 to about 50 percent by weight of citrate salt and hydrogen peroxide, and a remainder of water; and
removing the impurities from a substrate or an apparatus for forming an integrated circuit using the cleaning composition.

**4.** The method of claim 3, wherein the cleaning composition comprises:
about 2 to about 25 percent by weight of the citrate salt;
about 2 to about 25 percent by weight of hydrogen peroxide; and
a remainder of water.

**5.** The method of claim 3, wherein the impurities comprises at least one selected from the group consisting of aluminum, titanium, tungsten, copper, aluminum nitride, titanium nitride, tungsten nitride, copper nitride, aluminum silicide, titanium silicide, tungsten silicide, silicon oxide, silicon nitride and indium tin oxide (ITO).

**6.** The method of claim 3, wherein the substrate comprises a silicon wafer or a dummy wafer.

**7.** The method of claim 3, wherein the apparatus comprises at least one material selected from the group consisting of ceramic, aluminum, quartz and a stainless metal.

**8.** The method of claim 3, after removing the impurities using the cleaning composition, further comprising cleaning the substrate or the apparatus using an SC-1 solution including ammonium hydroxide, hydrogen peroxide and water, or an SC-2 solution including hydrochloric acid, hydrogen peroxide and water.
